# FASCICULE DE BREVET EUROPEEN

(11) **EP 1 697 975 B1**
(45) Date de publication et mention de la délivrance du brevet: **26.08.2009**
(21) Numéro de dépôt: 04816589.8
(22) Date de dépôt: 21.12.2004
(51) Int. Cl.: H01L 21/18

(54) **PROCEDE DE SCELLEMENT DE DEUX PLAQUES AVEC FORMATION D UN CO NTACT OHMIQUE ENTRE CELLES-CI**
VERFAHREN ZUM VERSIEGELN ZWEIER PLATTEN MIT AUSBILDUNG EINES OHMSCHEN KONTAKTS DAZWISCHEN
METHOD OF SEALING TWO PLATES WITH THE FORMATION OF AN OHMIC CONTACT THEREBETWEEN

(30) Priorité: 23.12.2003 FR 0351190
(43) Date de publication de la demande: 06.09.2006
(73) Titulaire: COMMISSARIAT A L'ENERGIE ATOMIQUE, 75015 Paris (FR)
(72) Inventeur: POCAS, Stéphane, F-38000 GRENOBLE (FR); MORICEAU, Hubert, F-38120 SAINT EGREVE (FR); MICHAUD, Jean-François, F-73800 ST PIERRE DE SOUCY (FR)
(74) Mandataire: Poulin, Gérard
(86) Numéro de dépôt international: PCT/FR2004/050742
(87) Numéro de publication internationale: WO 2005/064657

(56) Documents cités:
- DE-A- 3 829 906
- US-B1- 6 274 892
- SHIYANG ZHU ET AL: "Buried cobalt silicide layer under thin silicon film fabricated by wafer bonding and hydrogen-induced delamination techniques" J. ELECTROCHEM. SOC. (USA), JOURNAL OF THE ELECTROCHEMICAL SOCIETY, JULY 1999, ELECTROCHEM. SOC, USA, vol. 146, no. 7, juillet 1999 (1999-07), pages 2712-2716, XP002291929 ISSN: 0013-4651

## Description

### DOMAINE TECHNIQUE ET ART ANTERIEUR

L'invention concerne un procédé de scellement de deux plaques de matériaux semi-conducteurs, par exemple en silicium, avec formation d'un contact ohmique entre les deux plaques.

Dans la littérature, le scellement de deux plaques avec formation d'un contact ohmique est réalisé par l'intermédiaire d'un dépôt d'une couche métallique comme décrit par exemple dans le document de J. Haisma intitulé « Contact Bonding, Including Direct-Bonding in a Historical and Récent Context of Materials Science and Technology, Physics and Chemistry », Materials Science and Engineering, 37, 2002, p. 1-60. On peut, aussi citer le scellement eutectique, la brasure ou la formation d'un siliciure via une couche de métal déposé, comme décrit dans l'article de Z. X. Xiao et al. intitulé « Low Temperature Silicon Wafer to Wafer Bonding with Nickel Silicide, Journal of the Electrochemical Society, 145, 1998, p. 1360-1362.

Toutes ces techniques nécessitent le dépôt préalable d'une couche métallique. Or la tenue d'une couche métallique sur un support semi-conducteur n'est pas évidente à obtenir et nécessite des étapes technologiques particulières qui complexifient le scellement. Elles nécessitent également de préparer la surface de cette couche métallique (notamment sa chimie de surface et sa rugosité).

Il se pose donc le problème de trouver un nouveau procédé de scellement de plaques de matériaux semi-conducteurs, et notamment de plaques de silicium qui s'affranchissent de toutes ces étapes technologiques supplémentaires en évitant en particulier le dépôt d'une couche métallique.

Le document US 6 274 892 décrit :
- l'implantation, localisée ou non, de platine dans un substrat de silicium,
- l'assemblage direct de ce substrat à un autre substrat de silicium,
- un traitement thermique pour améliorer l'adhésion à une température de 400 à 700°C.

### EXPOSÉ DE L'INVENTION

Le procédé selon l'invention comporte une étape d'implantation d'espèces métalliques dans au moins un premier substrat, une étape d'assemblage par adhérence moléculaire avec un deuxième substrat, et une étape de recuit ou de formation d'un composé ou de composés conducteur(s) ou métallique(s), entre les espèces métalliques implantées et le ou les matériaux constitutifs des substrats ou résultant de ces espèces implantées et de ce ou ces matériaux, formant un contact ohmique entre les deux substrats au niveau de l'interface d'assemblage.

La formation d'un composé conducteur peut résulter d'un recuit ou d'un traitement thermique à une température au moins égale à la température de formation du ou des composés.

L'implantation des plaquettes de semi-conducteur, par exemple de silicium, par des espèces métalliques est de préférence réalisée à une très faible profondeur (quelques nanomètres) et à une dose comprise entre quelques 10¹⁴ et quelques 10¹⁸ espèces/cm² ou 10¹⁹ espèces/cm².

Pour réduire la profondeur d'implantation, il est possible de réaliser l'implantation à travers une couche superficielle formée sur le substrat à implanter, ou bien, après implantation, d'amincir le substrat implanté.

Une localisation de l'implantation peut être obtenue à travers un masque.

Après l'implantation, on vient assembler, par collage par adhérence moléculaire, la surface de la plaquette sur une autre plaquette.

La structure obtenue est recuite, de préférence à la température de formation d'un composé conducteur entre le métal implanté et le matériau (ou les matériaux) de surface des deux substrats à assembler. La zone implantée étant suffisamment proche de la surface, la formation de ce (ou ces) composé(s) conducteur(s) va alors être induite, et le collage par adhésion moléculaire sera modifié par la présence de ce(s) composé(s) conducteur(s).

Les matériaux collés peuvent être du silicium ou des matériaux semi-conducteurs autres que du silicium, pourvu que l'espèce implantée forme, lors du traitement thermique ultérieur, un composé conducteur avec le(s) matériau(x) de surface des substrats à assembler. En particulier, le matériau semi-conducteur peut être pris parmi les matériaux suivants : Si, GaAs, SiC, InP, Ge, SiGe.... Les deux matériaux collés peuvent être de nature différente.

Si il y a implantation dans les deux plaques, les espèces implantées peuvent être différentes pour les deux plaques, les conditions d'implantation d'une plaque à l'autre pouvant être différentes.

L'implantation peut se faire avec différentes espèces dans la même plaque, avec des conditions d'implantations qui peuvent être différentes d'une espèce à l'autre.

Le composé obtenu pour le contact ohmique peut être de type réfractaire, ce qui est avantageux en particulier pour des procédés ultérieurs à réaliser à haute température (par exemple croissance par épitaxie).

Après collage, et avant ou après recuit, un des substrats peut être aminci par les techniques classiques suivantes, prises seules ou en combinaison rodage, polissage, gravure chimique, gravure ionique....

L'un des substrats implantés peut être une hétérostructure, ou un assemblage d'au moins deux structures comportant deux matériaux différents, par exemple de type SOI (silicium sur isolant). En particulier, la couche superficielle peut être constituée de l'un des matériaux semi-conducteurs cités précédemment. Il est possible, après assemblage et avant ou après recuit, d'amincir cette hétérostructure pour ne laisser subsister que sa couche superficielle sur l'autre substrat (par exemple pour un substrat SOI, la couche superficielle de silicium). Cette couche superficielle peut elle-même contenir ou recouvrir une couche de circuits préalablement réalisée avant assemblage.

L'amincissement de l'hétérostructure peut être réalisé par les techniques classiques d'amincissement précédemment citées. Avantageusement, l'hétérostructure comportera une couche, enterrée ou non, présentant un caractère sélectif vis-à-vis du procédé d'amincissement choisi. Par exemple, pour les hétérostructures de type SOI, la couche d'oxyde de silicium enterrée peut jouer le rôle de couche d'arrêt, par exemple à la gravure chimique. D'autres couches d'arrêt pourront être prévues dans l'hétérostructure, par exemple une couche de SiGe ou de silicium dopé. On pourra également profiter par exemple de la sélectivité à la gravure du verre par rapport au silicium dans une hétérostructure de type silicium sur verre.

Dans un autre mode de réalisation avantageux, l'hétérostructure sera « démontable », et l'amincissement de cette hétérostructure sera alors obtenue par « démontage » de ladite hétérostructure. Le caractère « démontable » pourra en particulier être obtenu par assemblage de deux substrats au niveau d'une interface de collage dont l'énergie de collage est faible. Pour obtenir une telle interface, on pourra par exemple procéder à un collage moléculaire entre deux surfaces de rugosité, contrôlée comme décrit dans l'article d'Hubert Moriceau et al. « The Bonding Energy Control : an Original Way to Debondable Substrates ».

L'un des substrats peut comporter une couche ou un plan de fragilisation, par exemple obtenu par implantation d'espèces gazeuses ou par formation préalable d'une couche poreuse enterrée. Il est alors possible, par exemple après assemblage des deux substrats, d'amincir celui des substrats qui comporte cette couche de fragilisation en provoquant par exemple une fracture au niveau de la zone de séparation.

Les avantages du procédé selon l'invention sont multiples :
L'invention offre tout d'abord la possibilité de créer un contact ohmique avec n'importe quel métal implantable dans le substrat et formant un composé conducteur avec les matériaux des substrats à assembler.
De plus, le collage de plaquettes peut être fait par adhésion moléculaire, avec formation d'un contact ohmique sans avoir à maîtriser, ni le dépôt d'une couche de métal (rugosité, structure cristalline, adhérence de dépôt...), ni la chimie de sa surface (nettoyage, oxydation, ...) .

Il y a possibilité de coller des plaques avec un contact ohmique sur toute l'interface, ou de coller des plaques avec un contact ohmique localisé à des zones prédéfinies, par exemple par un masquage lors de l'implantation ou en utilisant une surface mixte faite de zones isolantes et de zones conductrices.

Enfin, il est possible de diminuer le budget thermique nécessaire pour renforcer le collage entre les deux substrats semi-conducteurs assemblés par adhérence moléculaire. En effet, dans un collage par adhérence moléculaire classique de deux substrats, en silicium par exemple, il est connu de l'art antérieur, par exemple dans l'ouvrage Tong-Gôsele « Semicondutor Wafer Bonding », 1998, The Electrochemical Society Series, John Wiley & Sons, Inc., qu'il faut, pour assurer un collage fort, effectuer sur la structure assemblée des traitements thermiques à des températures supérieures à environ 5.00°C. Dans le cas de l'invention, si au moins l'un des substrats de silicium est implanté d'ions Pd par exemple, le renforcement du collage aura lieu à la température de formation du Pd₂Si, c'est-à-dire autour de 150°C. On obtient ainsi des collages (Si/Si dans l'exemple) forts sans avoir recours à un traitement thermique à haute température.

Les composés métalliques peuvent être des alliages des matériaux semi-conducteurs des substrats au niveau de l'interface d'assemblage et d'au moins un métal choisi parmi le nickel, le palladium, le cobalt, la platine, la tantale, le tungstène, le titane, le cuivre....

Selon un mode de réalisation particulier, l'un au moins des substrats est un film mince.

L'un au moins des substrats peut comporter des composants électroniques et/ou optiques et/ou mécaniques.

Par exemple, l'un des substrats est un film mince en silicium comportant des circuits RF, l'autre substrat pouvant être en silicium de forte résistivité.

### BREVE DESCRIPTION DES FIGURES

- Les figures 1A - 3 représentent des étapes de divers procédés selon l'invention ;
- les figures 4A - 6B représentent des exemples de mise en oeuvre de divers procédés selon l'invention ;
- la figure 7 représente un substrat SOI.

### EXPOSÉ DÉTAILLÉ DE MODES DE RÉALISATION DE L'INVENTION

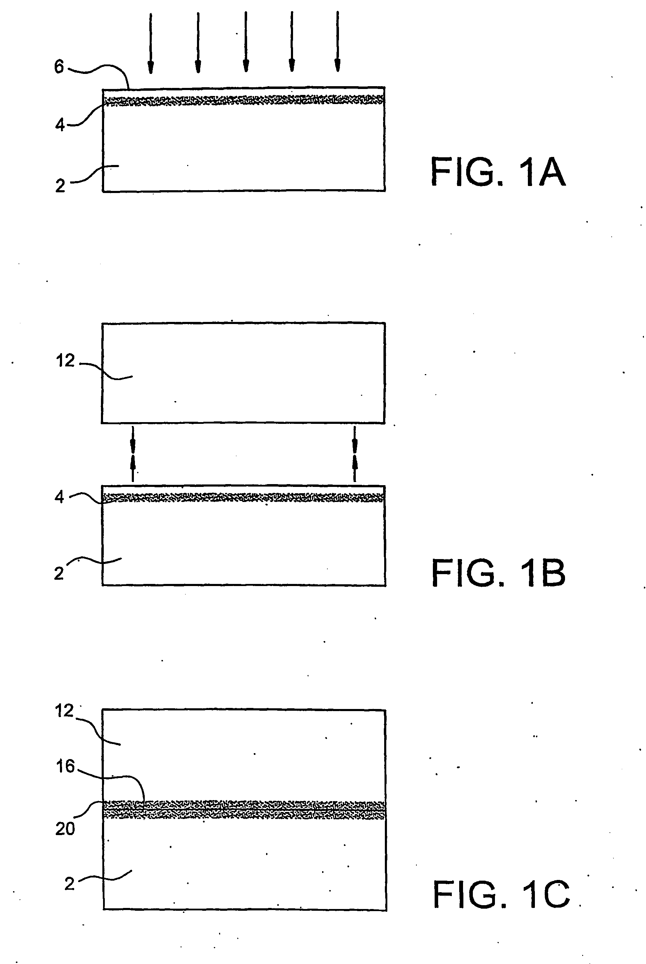

Un premier procédé selon l'invention, et des variantes de ce procédé, vont être décrits en liaison avec les figures 1A - 1C et 2A - 3.

Selon une première étape, on implante des espèces 4, atomiques ou ioniques, à proximité de la surface (dite supérieure) 6, mais sous cette surface, dans au moins une plaquette 2 en matériau semi-conducteur, par exemple en silicium.

Pour cela, plusieurs techniques sont possibles.

Selon une première technique, on implante par exemple une ou plusieurs espèces métalliques 4, par exemple du nickel et/ou du palladium et/ou du titane, et/ou du cobalt, et/ou du tantale, et/ou du platine, et/ou du tungstène, et/ou du cuivre.... à une très faible énergie, directement dans au moins un des substrats à assembler, par exemple de silicium : c'est le cas de la figure 1A. La faible énergie utilisée pour l'implantation assure une faible profondeur moyenne de pénétration Rp dans le substrat 2, typiquement de l'ordre de quelques nm, par exemple entre 5 nm et 10 nm.

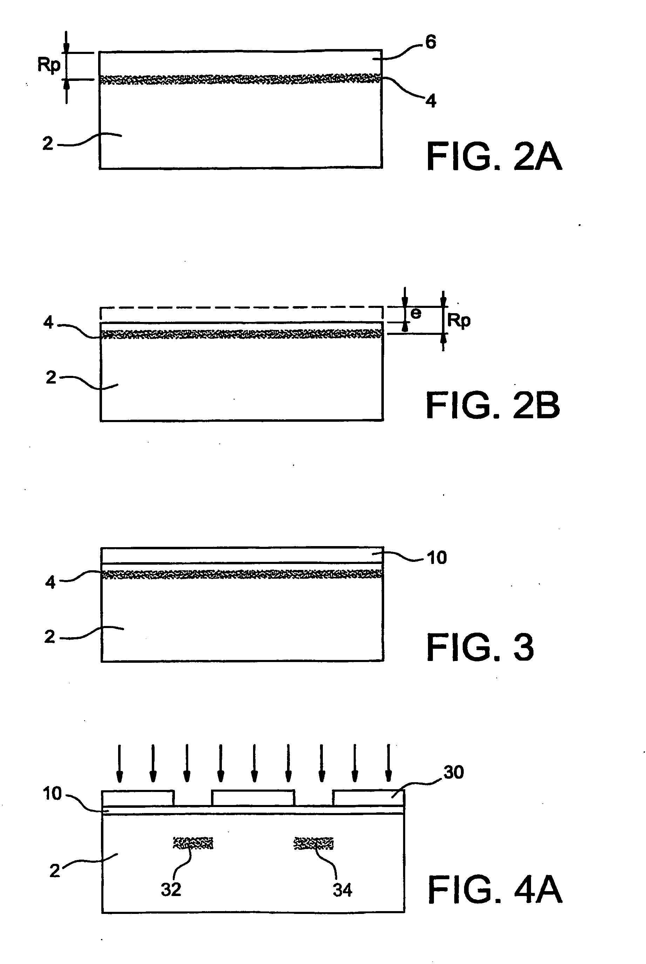

Selon une autre technique (figure 2A), on implante les ions métalliques cités ci-dessus à une plus forte énergie que précédemment, donc selon une profondeur moyenne Rp plus importante (par exemple comprise entre 10 nm et 20 nm), et on diminue ensuite l'épaisseur du film de silicium séparant la surface 6 de la zone implantée, par exemple par une attaque chimique, ou par une attaque mécanique, ou mécano chimique, ou par une gravure par plasma, ou par ablation laser, ou par faisceau d'ions, ou par une combinaison de ces techniques et/ou de celles classiquement utilisée en microélectronique. Une épaisseur e est ainsi éliminée (figure 2B), ce qui réduit d'autant la profondeur de la zone implantée.

Selon une variante (figure 3) on réalise une implantation ionique ou atomique à travers une couche mince sacrificielle 10, par exemple d'oxyde de silicium, que l'on élimine, après l'implantation, par exemple par attaque chimique dans du HF (acide fluorhydrique) à 1 %. Cela permet de limiter la profondeur de la zone implantée du substrat à assembler.

L'implantation peut être de type ionique, par diverses techniques de plasma ou par implantation par recul et/ou par mixage (« Ion Beam Mixing » en anglais). Elle peut être faite à une température autre qu'ambiante.

Une deuxième étape est celle de l'assemblage (figure 1B) de la paquette ou du substrat préparé selon l'une des techniques exposées ci-dessus, et d'une deuxième plaquette ou d'un deuxième substrat 12, en matériau semi-conducteur, par exemple lui aussi en silicium. Les surfaces de ces plaquettes 2, 12 peuvent être assemblées par collage suivant un mode hydrophile ou hydrophobe. On pourra se reporter, en ce qui concerne ces modes, à l'ouvrage de Q. Y. Tong et U. Gosele « Semiconductor Wafer Bonding » (Science and Technology), Wiley Interscience Publications. Le collage est ensuite réalisé par adhérence moléculaire.

On peut rendre les surfaces hydrophiles par exemple pour le silicium par un nettoyage chimique de type CARO (mélange H₂SO₄ : H₂O₂ par exemple dans le rapport 2 : 1 à 140°) et SCI (mélange NH₄OH : H₂O₂ : H₂O par exemple dans le rapport 1 :1 :5 à 70°), ou hydrophobes par un nettoyage terminé par un traitement HF (à l'acide fluorhydrique dilué par exemple à 1 %).

En outre des techniques de préparation des surfaces, telles que par exemple l'activation par plasma utilisant un couplage capacitif (par exemple de type attaque ionique réactive dite « RIE » en anglais) ou un couplage inductif (par exemple de type attaque hors plasma dite « after glow » en anglais ou de type gravure sèche chimique dite « chemical dry etching » en anglais), peuvent être utilisées. Ces techniques permettent, d'une part, d'amincir le substrat auquel elles sont appliquées, comme déjà décrit ci-dessus en liaison avec la figure 2B, et/ou d'autre part d'activer des espèces qui sont en surface du substrat. L'activation plasma peut se faire avec, par exemple, des gaz pris seuls ou en combinaison comme l'oxygène, l'argon, l'azote, l'hydrogène, SF₆, CF₆, CF₄, CHF₃... .

De même la technique de polissage mécano chimique, qui allie les avantages d'amincissement et de préparation des surfaces des plaquettes, peut être utilisée.

Pour la troisième étape (figure 1C), après le collage, la structure est recuite, de préférence au moins à la température de formation d'un composé conducteur résultant du matériau des substrats et du métal implanté, par exemple pour la formation d'un des siliciures du métal implanté si les deux substrats à assembler sont en silicium. Cette température est par exemple de l'ordre de 350°C pour le siliciure de nickel (NiSi). Cette température dépend du composé métallique à former. On peut, pour déterminer cette température, se référer à des tables de référence comme celle de A. Nicollet et S. S Lau pour les composés métalliques siliciurés (VLSI Handbook p. 422, 1985).

Les espèces implantées vont alors diffuser et interagir pour former un composé conducteur 20 au voisinage de l'interface 16 de collage, et donc modifier celle-ci. Ce composé renforce l'assemblage des deux substrats.

Le deuxième substrat (désigné par la référence 12 sur la figure 1B) peut être un substrat de même nature que le substrat 2, ou même un substrat ou une plaquette identique au substrat ou à la plaquette 2. Il peut être lui aussi implanté avec des ions ou des atomes métalliques, identiques ou différents de ceux implantés dans le substrat 2.

Selon un autre mode de réalisation, le substrat 12 et/ou le substrat 2 peuvent être des hétérostructures, par exemple de type SOI.

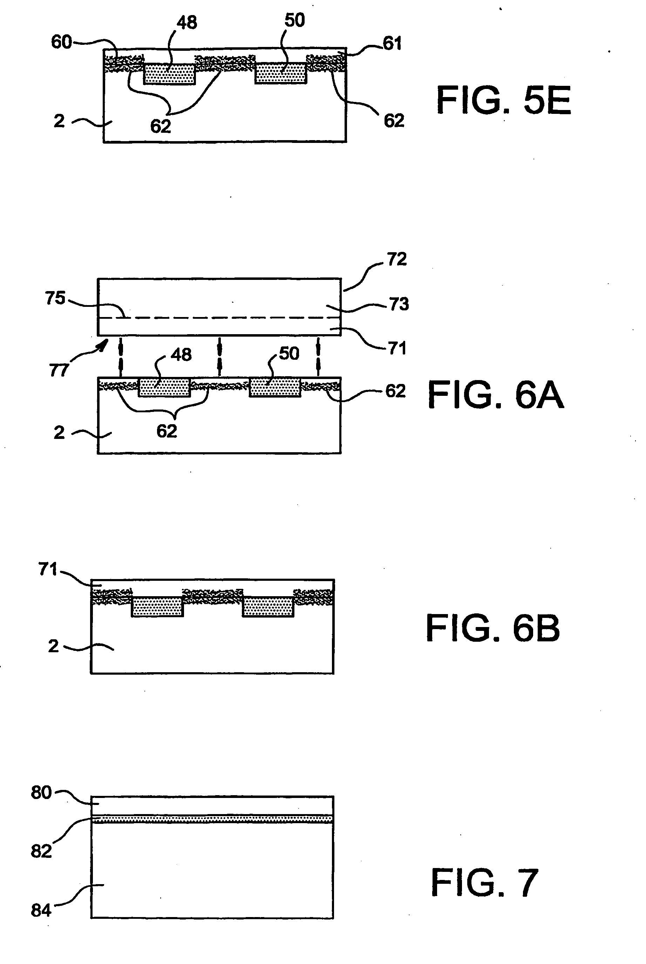

Comme illustré sur la figure 7, une structure SOI (abréviation de Silicon on Insulator, ou Silicium sur Isolant) comporte, typiquement, une couche de silicium 80, réalisée sur une couche enterrée 82 d'oxyde de silicium, qui repose elle-même sur un substrat 84 en silicium, ce dernier jouant le rôle de support mécanique. De telles structures sont par exemple décrites dans l'ouvrage de S. S. Iyer et al. intitulé « Silicon Wafer Bonding Technology », INSPEC, 2002.

Typiquement, dans l'exemple du SOI, la couche 80 a une épaisseur comprise entre quelques nanomètres (par exemple 10 ou 50 nm) et quelques centaines de micromètres (par exemple 100 ou 150 µm).

La couche d'isolant 82 peut avoir une épaisseur comprise entre quelques nanomètres et quelques dizaines de micromètres, par exemple 20µm.

Il est possible d'assembler un tel substrat SOI, avec un substrat, de type SOI ou non, au moins l'un de ces deux substrats étant implanté selon la présente invention, comme illustré sur la figure 1B :
c'est alors la couche superficielle 80 du SOI qui est assemblée contre la face supérieure du substrat 2.

### DES EXEMPLES D'APPLICATIONS VONT ETRE DONNES :

**Exemple 1 :** On implante des ions Ni⁺ dans une plaquette 2 de silicium, recouverte d'un film 10 d'oxyde de silicium (figure 3) d'épaisseur 5 nm, à une dose de 2.10¹⁷ ions/cm² et une énergie de 10 keV. Le Rp d'implantation se situe, selon le logiciel de simulation SRIM-2000, à une profondeur d'environ 12nm et à environ 7nm de la surface de silicium. Après l'implantation, on retire l'oxyde de silicium 10 et on vient coller directement une deuxième plaquette 12 de silicium, implantée ou non (figure 1B). On réalise un recuit de siliciuration à environ 300°C afin de former le siliciure Ni₂Si 20, qui se formera jusqu'à, et au-delà de l'interface de collage 16 (figure 1C).

Dans une variante de cet exemple, on pourra après implantation, déposer une couche intermédiaire (de silicium amorphe par exemple) sur le substrat implanté. L'épaisseur de cette couche sera choisie compatible avec la formation de l'alliage au niveau de l'interface de collage. Au besoin, cette couche intermédiaire pourra être amincie avant collage. Cette couche pourra par exemple être choisie pour faciliter le collage par adhérence moléculaire.

**Exemple 2 :** On implante des ions Ni+ directement dans une plaquette 2 de silicium à une dose de 3.10¹⁷ ions/cm² et à une énergie de 10 keV (figure 2A). Le Rp d'implantation se situe, selon le logiciel de simulation SRIM-2000, à une profondeur d'environ 13nm. Afin de pouvoir rapprocher le Rp d'implantation de la surface, on grave le silicium, par exemple avec une solution chimique de type SC1 (voir précédemment) jusqu'à ce que le Rp d'implantation se situe proche de la surface (figure 2B), par exemple à une profondeur de l'ordre de 5 nm. On vient ensuite coller directement une deuxième plaque 12 de silicium (figure 1B). On réalise, ensuite, un recuit de siliciuration à environ 300°C afin de former le siliciure Ni₂Si qui se formera jusqu'à et au-delà de l'interface de collage 16 (figure 1C) .

Une variante de cet exemple consiste à rendre amorphe tout ou partie de la couche superficielle du substrat 2. En effet, l'amorphisation du matériau (ici le silicium) va favoriser la diffusion de l'espèce implantée dans ce matériau. Si le matériau amorphe est présent en surface, la diffusion vers l'interface est donc facilitée. Pour rendre amorphe la partie superficielle du substrat 2, plusieurs techniques sont possibles. On peut, avant et/ou après implantation, déposer sur le substrat de silicium par exemple, une couche de matériau amorphe, par exemple du silicium amorphe qui peut au besoin être amincie. On procède ensuite à l'implantation des ions, par exemple Ni+ comme dans l'exemple précédent. Suivant l'épaisseur de la couche amorphe, l'implantation peut avoir lieu dans la couche amorphe ou dans le substrat initial. On peut alors procéder aux étapes d'assemblage avec le deuxième substrat et de traitement thermique pour provoquer la création d'un composé métallique, jusqu'à et au-delà de l'interface, dans l'exemple le siliciure Ni₂Si. On peut également amorphiser la surface de substrat 2 par implantation, selon les techniques connues de l'homme de métier, par exemple par implantation d'hydrogène. Cette implantation peut être locale ou globale sur toute la surface du substrat. Elle peut être réalisée avant ou après l'implantation d'espèces métalliques selon l'invention, cette implantation d'espèces métalliques pouvant également participer pour tout ou partie à cette étape d'amorphisation.

**Exemple 3 :** Une variante de l'exemple 2 consiste à implanter l'espèce Ni⁺ à une dose de 2.10¹⁷ ions/cm² et à une énergie de 10 keV. Le Rp d'implantation se situe selon le logiciel de simulation SRIM-2000 à une profondeur d'environ 13nm. Afin de pouvoir rapprocher le Rp d'implantation de la surface, on grave le silicium par exemple avec une solution chimique de type SC1 jusqu'à ce que le Rp d'implantation se situe proche de l'interface (figure 2B). On effectue ensuite un traitement par plasma argon, avant collage, pour renforcer l'énergie de collage moléculaire à basse température. Une fois collée, la structure est recuite à la température de formation du siliciure afin de former le siliciure Ni2Si qui se formera jusqu'à et au-delà de l'interface de collage (figure 1C).

**Exemple 4 :** On implante des ions Ni⁺ dans deux plaquettes de silicium, chacune à une dose de 2.10¹⁷ ions/cm² et à une énergie de 10 keV. Le Rp d'implantation se situe selon le logiciel de simulation SRIM-2000, à une profondeur d'environ 13nm dans chaque plaquette. Afin de pouvoir rapprocher le Rp d'implantation de la surface de chaque plaquette, on grave chacune des plaquettes, par exemple avec une solution chimique de type SC1. On colle ensuite les deux plaquettes l'une contre l'autre. On réalise ensuite un recuit de siliciuration à environ 750°C afin de former le siliciure NiSi₂ qui se formera à l'interface de collage des plaquettes collées.

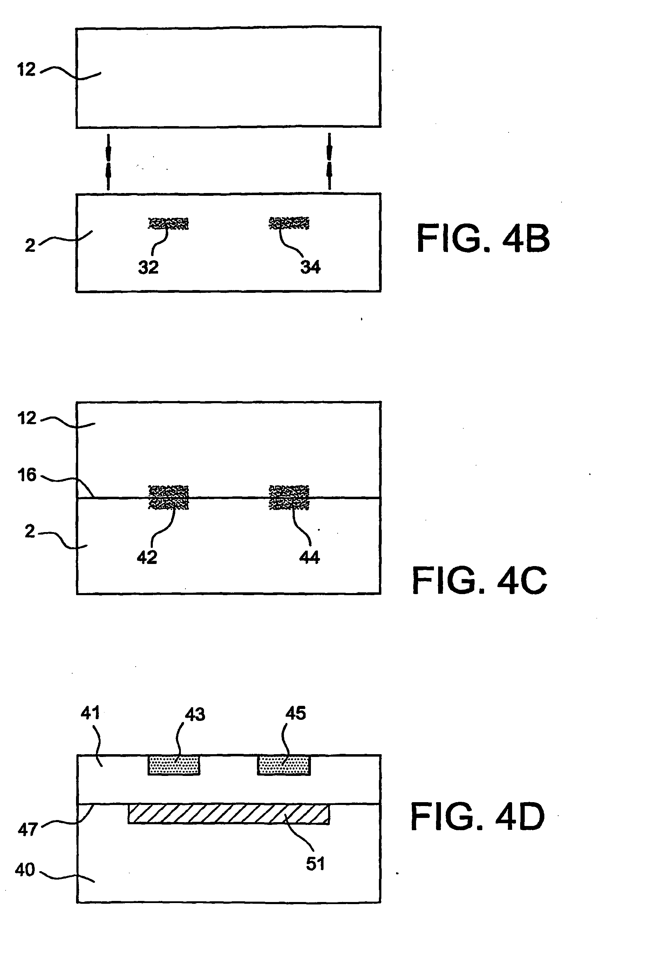

**Exemple 5 :** On désire coller deux plaques avec un contact ohmique localisé. On implante des ions Ni⁺ dans une plaquette de silicium recouverte d'une couche 10 d'oxyde de silicium (d'épaisseur 5nm) à une dose de 2.10¹⁷ ions/cm² et à une énergie de 10 keV, à travers un masque 30 d'implantation (figure 4A). On obtient ainsi un substrat localement implanté selon des zones 32, 34. Le Rp d'implantation se situe, selon le logiciel de simulation SRIM-2000 à une profondeur d'environ 12 nm, et à environ 7 nm de la surface de silicium. Après l'implantation, on retire l'oxyde de silicium 10 et on vient coller directement une deuxième plaquette 12 de silicium, implantée ou non (figure 4B). On réalise un recuit à environ 750°C qui servira d'une part à former le siliciure NiSi₂, en deux zones 42, 44 localisées, et qui servira d'autre part à renforcer le collage silicium :silicium au niveau des autres zones (figure 4C).

Une structure particulièrement intéressante résultant du procédé qui vient d'être décrit est illustrée figure 4D. Elle se compose d'un substrat 40 de silicium de forte résistivité (obtenu par exemple par la technique d'élaboration dite « floating zone » de triage par fusion de zone), et d'un film mince 41 de silicium comportant des composants RF 43, 45 (par exemple en surface), l'interface 47 entre le substrat et le film mince comportant localement un composé métallique (par exemple un siliciure de nickel) obtenu par le procédé de l'invention, ce composé métallique 51 jouant le rôle de plan de masse. Dans cette structure, le film mince 41 de silicium peut provenir de l'amincissement d'un SOI ou d'un substrat de silicium. Les composants RF 41, 43 peuvent être réalisés avant et/ou après la formation du composé métallique suivant la compatibilité de ces procédés (en particulier dans leurs aspects budget thermique).

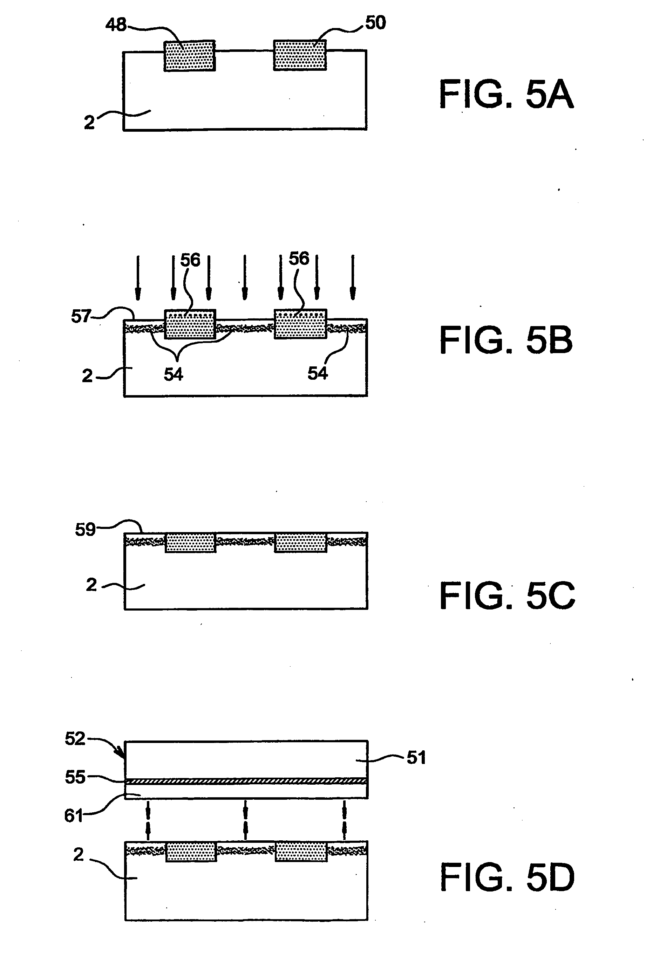

**Exemple 6 :** Cet exemple est une variante de l'exemple 5. Le substrat 2 comporte, à sa surface, des zones isolantes localisées 48, 50, part exemple en SiO₂ (voir figure 5A). On implante ensuite des ions Ni+ dans ce substrat à une dose de 2.10¹⁷ ions/cm² et une énergie de 10 keV (voir figure 5B). On obtient des zones implantées 54, 56 dont le Rp d'implantation se situe à une profondeur d'environ 13nm dans le silicium (hors zones isolantes), et au dessus de la surface de silicium dans les zones isolantes 48, 50. On retire ensuite la portion d'isolant qui dépasse au-dessus de la surface 57 de silicium, et, éventuellement, une partie du silicium hors des zones isolantes (voir figure 5C), par exemple par polissage mécano-chimique. On laisse ainsi une surface plane 59, apte à être collée par adhérence moléculaire sur une autre plaquette 52, par exemple une plaquette de silicium sur isolant (SOI) (voir figure 5D). On réalise ensuite un recuit de siliciuration, à environ 750°C, afin de former le siliciure NiSi₂ 62 qui se formera au voisinage de l'interface de collage et renforcera le collage hors des zones de siliciuration 48, 50. On élimine ensuite le silicium 51 (face arrière) de la plaquette SOI 52, jusqu'à l'oxyde de silicium 55. En variante, si la plaquette 52 est en silicium massif, on procède à un amincissement de cette plaquette selon les techniques classiques précédemment décrites. On obtient ainsi, dans les deux cas, un film mince 61, en partie sur l'isolant 48, 50 et en partie sur des zones conductrices 62 (voir figure 5E). Ce mode de réalisation permet donc d'obtenir une interface localement conductrice.

**Exemple 7 :** Cet exemple est une variante de l'exemple 6. Une plaquette de SOI 52, comportant des circuits déjà fabriqués dans ou sur la couche 61 est assemblée avec une plaquette 2 implantée, comportant des zones isolantes localisées (figure 5D). Dans ce cas, la face en regard de la plaquette 2 en silicium implanté est un film processé 61, par exemple une couche de circuits, recouvert par exemple par du silicium amorphe déposé par exemple par pulvérisation. La couche 61 de silicium, munie de sa couche de circuits, peut aussi avoir été d'abord transférée sur une plaquette poignée intermédiaire, cette dernière permettant ensuite un deuxième transfert sur la plaquette 2 : dans ce cas, la face en regard de la plaquette 2 en silicium implanté est la couche de silicium 61, surmontée de sa couche de circuits. On réalise ensuite un recuit de siliciuration à environ 750°C afin de former le siliciure NiSi₂, qui se formera au voisinage de l'interface de collage. Ce traitement thermique permet également de renforcer le collage hors des zones de siliciuration. On élimine ensuite le silicium 51 (face arrière) de la plaquette SOI 52 et l'oxyde de silicium 55. On obtient alors (figure 5E) un film mince 61 processé, en partie sur de l'isolant 48, 50 et en partie sur des zones conductrices 62. De manière analogue on pourra au lieu de la plaquette de SOI 52 utiliser une hétérostructure démontable.

**Exemple 8 :** C'est une variante des deux exemples 6 et 7. Elle consiste à coller, non pas un SOI, mais une plaque 72 (figure 6A) préparée pour permettre de détacher une couche superficielle 71 (processée ou non) d'un substrat 73, par exemple par la technique de fracturation de substrat, telle que « smart-cut » ou par exemple par une technique mettant en oeuvre une couche d'arrêt 75 dans la structure. Cette couche d'arrêt peut être de nature épitaxiale (SiGe, Si dopé, ...) ou poreuse (Si poreux, ...) ou amorphe (SiN4, ...).

Après assemblage, recuit et fracture de la plaque 71, on obtient la structure de la figure 6B.

La préparation de la plaque 72 pour en détacher une couche superficielle peut comporter une implantation atomique ou ionique, par exemple d'ions hélium ou hydrogène, formant une mince couche 75 de fragilisation qui s'étend sensiblement parallèlement à une surface 77 du substrat 73 (figure 6A). En fait est ainsi formée une couche ou un plan de fragilisation ou de fracture 75.

La fracture peut alors être réalisée par la technique dite « smart-cut », dont un exemple est décrit dans l'article de A. J. Auberton-Hervé et al. « Why Can Smart-Cut Change the Future of Microelectronics ? » paru dans International Journal of High Speed Electronics and Systems, Vol. 10, N°1 (2000), p. 131-146.

La formation d'un plan de fragilisation peut être obtenue par d'autres méthodes, par exemple par formation, d'une couche de silicium poreux, comme décrit dans l'article de K. Sataguchi et al. « ELTRAN® by Splitting Porous Si layers », Proceedings of the 9th International Symposium on Silicon-on-Insulator Tech. and Device, 99-3, The Electrochemical Society, Seattle, p. 117-121 (1999).

**Exemple 9 :** On implante des ions Pd+ dans une plaquette de silicium à une dose de 2.10¹⁷ ions/cm² et une énergie de 10 keV, selon l'une des techniques décrites ci-dessus (voir figure 2A par exemple). Le Rp d'implantation se situe à une profondeur d'environ 13nm. Afin de pouvoir rapprocher le Rp d'implantation, on grave le silicium par exemple avec une solution chimique de type SC1 jusqu'à ce que le Rp d'implantation se situe, proche de la surface (figure 2B). On vient ensuite coller directement une deuxième plaquette de silicium (figure 1B). On réalise ensuite un recuit de siliciuration à environ 200°C afin de former le siliciure Pd₂Si qui se formera au voisinage de l'interface de collage (figure 1C) . L'avantage de la technique est de pouvoir abaisser la température de renforcement du collage silicium-silicium à la température de siliciuration (ici 200°C), alors qu'il faudrait habituellement un traitement thermique à une température supérieure à 500°C.

**Exemple 10 :** L'invention peut être mise en oeuvre avec des substrats de matériaux différents. Par exemple, pour assembler une plaquette de silicium avec une plaquette de GaAs selon l'invention, on pourra procéder de la manière suivante : on implante, au moins dans une des plaquettes, des ions Pd+, par exemple dans la plaquette de silicium avec une dose de l'ordre de 3.10¹⁷/cm². On procède ensuite à l'assemblage par adhérence moléculaire des deux plaquettes puis à un recuit, typiquement autour de 200°C. on provoque alors la formation de Pd₂Si dans le silicium et de Pd₄GaAs dans la plaquette de GaAs. Ces deux composés métalliques assurent alors le scellement selon l'invention.

D'autres éléments métalliques, présentant aussi une température relativement basse de formation d'un composé conducteur (résultant de l'alliage avec le matériau de substrat), pourront être sélectionnés par exemple à l'aide des tables de références déjà mentionnées ci-dessus.

L'invention peut être mise en oeuvre avec deux substrats implantés, par exemple selon l'une des techniques décrites ci-dessus en liaison avec les figures 1A - 3. Les substrats assemblés peuvent être en matériaux différents, avec des implantations d'espèces différentes, et un même substrat peut être implanté avec des espèces différentes.

Des techniques mentionnées ci-dessus, telles que celles d'assemblage de substrats, de fracturation de substrat, ainsi que des composants SOI, sont décrits dans l'ouvrage de S. S. Iyer et al. « Silicon Wafer Bonding Technology » INSPEC, 2002.

## Revendications

1. Procédé de scellement de deux plaques (2, 12) de matériaux semi-conducteurs, comportant :
- une étape d'implantation d'espèces métalliques (4) dans au moins la première plaque, à travers une surface d'assemblage avec la deuxième plaque,
- une étape d'assemblage de la première et de la deuxième plaque, par adhérence moléculaire,
- une étape de formation de composés métalliques (20), formant un contact ohmique entre les deux plaques au niveau de l'interface d'assemblage de ces plaques, alliages entre les espèces métalliques implantées et les matériaux semi-conducteurs des deux plaques.

2. Procédé selon la revendication 1, l'étape de formation de composés métalliques résultant d'un traitement thermique à une température au moins égale à la température de formation desdits composés.

3. Procédé selon la revendication 1 ou 2, l'implantation d'espèces métalliques étant réalisée à une profondeur (Rp) comprise entre 5 nm et 20 nm sous la surface (6) de la plaque implantée.

4. Procédé selon l'une des revendications 1 à 3, l'implantation d'espèces métalliques étant réalisée à une dose comprise entre 10¹⁴ et quelques 10¹⁸ espèces/cm².

5. Procédé selon l'une des revendications 1 à 4, comportant en outre, avant assemblage, une étape, d'amorphisation destinée à rendre amorphe tout ou partie de la couche superficielle de la première plaque.

6. Procédé selon la revendication 5, l'étape d'amorphisation comportant le dépôt, avant et/ou après implantation d'espèces métalliques, d'une couche de matériau amorphe.

7. Procédé selon la revendication 5, l'étape d'amorphisation comportant une implantation de la surface, par exemple par de l'hydrogène ou des espèces métalliques.

8. Procédé selon l'une des revendications 1 à 7, les plaques étant chacune en un matériau choisi parmi le silicium, l'arséniure de gallium (GaAs), le SiC (carbure de silicium), le InP (Phosphure d'indium), le Germanium (Ge), le silicium - Germanium (SiGe).

9. Procédé selon l'une des revendications 1 à 8, les espèces implantées étant des espèces Nickel et/ou palladium et/ou Cobalt, et/ou Platine, et/ou Tantale, et/ou Tungstène, et/ou Titane, et/ou Cuivre.

10. Procédé selon l'une des revendications 1 à 9, l'une au moins des plaques (12) étant une hétérostructure, par exemple de type SOI.

11. Procédé selon l'une des revendications 1 à 10, l'une au moins des plaques étant amincie, après assemblage ou après l'étape de formation des composés métalliques.

12. Procédé selon l'une des revendications 1 à 11, l'une au moins des plaques étant une structure démontable.

13. Procédé selon l'une des revendications 1 à 12, l'une au moins des plaques comportant un plan de fragilisation.

14. Procédé selon la revendication 13 la plaque comportant un plan de fragilisation étant amincie par fracture le long dudit plan de fragilisation, après assemblage ou après l'étape de formation de composés métalliques.

15. Procédé selon l'une des revendications 1 à 14, l'une au moins des plaques comportant au moins un circuit ou une couche de circuits sur, ou près de, sa face à assembler.

16. Procédé selon l'une des revendications 1 à 15, l'étape d'implantation d'espèces métalliques étant réalisée à travers un masque (30) pour obtenir des zones d'implantation locales (32, 34).

17. Procédé selon l'une des revendications 1 à 15, comportant en outre la formation d'une couche d'isolant (20) sur la première plaque, avant son implantation d'espèces métalliques.

18. Procédé selon l'une des revendications 1 à 17, comportant en outre, après implantation d'espèces métalliques, une étape d'amincissement de la plaque implanté.

19. Procédé selon l'une des revendications 1 à 18, la première plaque comportant au moins une zone isolante (48, 50) localisée en surface permettant d'obtenir des zones (54) d'implantation locales.

## Claims

1. Sealing processing for two wafers (2, 12) made of semiconducting materials, comprising:
- a step for implantation of metallic species (4) in at least the first wafer, through an assembly surface with the second wafer,
- a step for assemble of the first and second wafer by molecular bounding,
- a step for formation of metallic compounds (20), forking an ohmic contact between the two wafers at the assembly interface of these wafers, alloys between the implanted metallic species and the semiconducting materials of the two wafers.

2. Process according to claim 1, the formation step of the metallic compounds resulting from a heat treatment at a temperature equal at least to the formation temperature of the said compounds.

3. Process according to claim 1 or 2, the metallic species being implanted at a depth (Rp) of between 5 nm and 20 nm under the surface (6) of the implanted wafer.

4. Process according to one of claims 1 to 3, the metallic species being implanted at a dose of between 10¹⁴ and a few 10¹⁸ species/cm².

5. Process according to one of claims 1 to 4, also comprising an amorphisation step before assemble to make all or part of the surface layer of the first wafer amorphous.

6. Process according to claim 5, the amorphisation step comprising deposition of an amorphous material layer before and/or after implantation of metallic species.

7. Process according to claim 5, the amorphisation step comprising a surface implantation, for example by hydrogen or metallic species.

8. Process according to one of claims 1 to 7, each at the wafers being made from a material chosen from among silicon, gallium arsenide (GaAs), SiC (silicon carbide), InP (Indium phosphide), Germanium (Ge), le Silicon - Germanium (SiGe).

9. Process according to one of claims 1 to 8, the implanted species being Nickel and/or palladium and/or Cobalt, and/or Platinum, and/or Tantalum, and/or Tungsten, and/or Titanium, and/or Copper.

10. Process according to one of claims 1 to 9, at least one of the wafers (12) being a heterostructure, for example of the SOI type.

11. Process according to one of claims 1 to 10, at least one of the wafers being thinned, after assembly or after the formation step of metallic compounds.

12. Process according to one of claims to 11, at least one of the wafers being a debondable structure.

13. Process according to one of claims 1 to 12, at least one of the wafers comprising a weakening plane.

14. Process according to claim 13, the wafer comprising a weakening plane being thinned by fracture alone the said weakening plane, after assemble or after the formation step of the metallic compounds.

15. Process according to one of claims 1 to 14, at least one of the wafers comprising at least one circuit or circuits layer, on or close to its face to be assembled.

16. Process according to one of claims 1 to 15, the implantation step of metallic species being done through a mask (30) to obtain local implantation zones (32, 34).

17. Process according to one of claims 1 to 15, also comprising the formation of an insulating layer (20) on the first wafer, before it is implanted with metallic species.

18. Process according to one of claims 1 to 17, also comprising a thinning step of the implanted wafer after implantation of metallic species.

19. Process according to one of claims 1 to 18, the first wafer comprising at least one insulating zone (48, 50) located at the surface so as to obtain local implantation zones (54).

## Patentansprüche

1. Verfahren zum Versiegeln zweier Platten (2, 12) aus Halbleitermaterial, umfassend:
- einen Schritt zur Implantation metallischer Spezies bzw. Ionen (4) in wenigstens einer ersten Platte durch eine für den Zusammenbau mit der zweiten Platte vorgesehene Oberfläche hindurch,
- einen Schritt des Zusammenbaus der ersten mit der zweiten Platte durch molekulare Adhäsion,
- einen Schritt zur Bildung metallischer, einen ohmschen Kontakt zwischen den beiden Platten in Höhe der Zusammenbaugrenzfläche dieser Platten bildenden Verbindungen (20), Legierungen aus den implantierten metallischen Spezies und den Halbleitermaterialien der beiden Platten.

2. Verfahren nach Anspruch 1, wobei der Schritt zur Bildung metallischer Verbindungen aus einer thermischen Behandlung mit einer Temperatur wenigstens gleich der Temperatur zur Bildung der genannten Verbindungen resultiert.

3. Verfahren nach Anspruch 1 oder 2, wobei die Metallionen-Implantation in einer Tiefe (Rp) erfolgt, enthalten zwischen 5 nm und 20 nm unter der Oberfläche (6) der implantierten Platte.

4. Verfahren nach einem der Ansprüche 1 bis 3, wobei die Metalionen-Implantation mit einer zwischen 10¹⁴ und ungefähr 10¹⁸ Ionen/cm² enthaltenen Dosis erfolgt.

5. Verfahren nach einem der Ansprüche 1 bis 4, außerdem vor dem Zusammenbau einen Amorphisierungsschritt umfassend, dazu bestimmt, die Oberflächenschicht der ersten Platte ganz oder teilweise amorph zu machen.

6. Verfahren nach Anspruch 5, wobei der Amorphisierungsschritt das Abscheiden einer Schicht aus amorphem Material vor und/oder nach der Metallionen- Implantation umfasst.

7. Verfahren nach Anspruch 5, wobei der Amorphisierungsschritt eine Implantation von der Oberfläche umfasst, zum Beispiel durch Wasserstoff oder metallische Spezies.

8. Verfahren nach einem der Ansprüche 1 bis 7, wobei jede der Platten aus einem unter Silicium, Galliumarsenid (GaAs), SiC (Siliciumcarbid), InP (Indiumphosphid), Germanium (Ge), Silicium-Germanium (SiGe) ausgewählte Material ist.

9. Verfahren nach einem der Ansprüche 1 bis 8, wobei die implantierten Ionen Nickel- und/oder Palladium- und/oder Kobalt- und/oder Platin- und/oder Tantal- und/oder Wolfram und/oder Titan und/oder Kupfer-Ionen sind.

10. Verfahren nach einem der Ansprüche 1 bis 9, wobei wenigstens eine der Platten (12) eine Heterostruktur, zum Beispiel des Typs SOI, ist.

11. Verfahren nach einem der Ansprüche 1 bis 10, wobei wenigstens eine der Platten nach dem Zusammenbau oder nach dem Schritt zur Bildung der metallischen Verbindungen gedünnt wird.

12. Verfahren nach einem der Ansprüche 1 bis 11, wobei wenigstens eine der Platten eine demontierbare Struktur ist.

13. Verfahren nach einem der Ansprüche 1 bis 12, wobei wenigstens eine der Platten eine Schwächungsebene umfasst.

14. Verfahren nach Anspruch 13, wobei die eine Schwächungsebene umfassende Platte durch Frakturierung längs der genannten Schwächungsebene gedünnt wird, nach dem Zusammenbau oder nach dem Schritt zur Bildung der metallischen Verbindungen.

15. Verfahren nach einem der Ansprüche 1 bis 14, wobei wenigstens eine der Platten wenigstens eine Schaltung oder eine Schaltungsschicht aus - oder naheihrer Zusammenbaufläche umfasst.

16. Verfahren nach einem der Ansprüche 1 bis 15, wobei der Schritt zur Implantation metallischer Spezies bzw. Ionen durch eine Maske (30) hindurch ausgerührt wird, um lokale Implantationszonen (32, 34) zu erhalten.

17. Verfahren nach einem der Ansprüche 1 bis 15 mit außerdem der Bildung einer isolierenden Schicht (20) auf der ersten Platte, vor ihrer Implantation mit metallischen Spezies bzw. Ionen.

18. Verfahren nach einem der Ansprüche 1 bis 17 mit außerdem - nach der Metallionenimplantation - einem Dünnangsschritt der implantierten Platte.

19. Verfahren nach einem der Ansprüche 1 bis 18, wobei die erste Platte wenigstens eine an der Oberfläche lokalisierte Isolierzone (48, 50) umfasst, die ermöglicht, lokale Implantationszonen (54) zu erhalten.
